# EUROPEAN PATENT APPLICATION

(11) **EP 4 524 624 A1**
(43) Date of publication of application: **19.03.2025**
(21) Application number: 23803443.3
(22) Date of filing: 26.04.2023
(51) Int. Cl.: G02B 5/20, F21V 9/30, F21V 29/502, F21V 29/70, G02B 5/00, G02B 7/182, H05K 7/20

(54) **WAVELENGTH CONVERSION MEMBER AND LIGHT SOURCE DEVICE**

(30) Priority: 13.05.2022 JP 2022079229
(71) Applicant: Niterra Co., Ltd., Nagoya-shi, Aichi 461-0005 (JP)
(72) Inventor: YATSUYA Yosuke, Nagoya-shi, Aichi 461-0005 (JP); BAN Shinji, Nagoya-shi, Aichi 461-0005 (JP); SAKURAI Toshiyuki, Nagoya-shi, Aichi 461-0005 (JP); TANAKA Tomoo, Nagoya-shi, Aichi 461-0005 (JP)
(74) Representative: Grünecker Patent- und Rechtsanwälte PartG mbB
(86) International application number: PCT/JP2023/016466
(87) International publication number: WO 2023/218964

(57) **Abstract**

A wavelength conversion member, including a fluorescent body capable of emitting fluorescence by excitation light, and having an incident surface which the excitation light enters and a back surface disposed on the side opposite to the incident surface, and a reflection film disposed on the back surface side of the fluorescent body and formed of a metal layer and particles contained in the metal layer. The wavelength conversion member is characterized in that the particles have a melting point higher than that of the metal forming the metal layer; the reflection film has a first surface facing the back surface of the fluorescent body, and a second surface disposed on the side opposite to the first surface; and the particles are contained in an amount greater on the second surface side than on the first surface side.

## Description

### Technical Field

The present invention relates to a wavelength conversion member and to a light source device.

### Background Art

Hitherto, there has been known a wavelength conversion member that can convert excitation light emitted from a light source to fluorescence having a different wavelength. Generally, a wavelength conversion member has a fluorescent body for converting the wavelength of excitation light, and a reflection film disposed on the side opposite the excitation light irradiation side in the fluorescent body. For example, Patent Document 1 discloses a wavelength conversion member having a converter formed of a fluorescent body, and a metal-containing coating serving as a reflection film. In the metal-containing coating of the wavelength conversion member, a metal such as silver is incorporated into glass, so as to enhance wettability between silver and the fluorescent body.

### Prior Art Documents

### Patent Documents

Patent Document 1: Japanese Translation of PCT International Application Publication No. 2016-534396

### Summary of the Invention

### Problems to be Solved by the Invention

According to Patent Document 1, when the metal-containing coating is baked to form a reflection film on a converter, the glass contained in the coating is heated to a temperature at which the glass is melted. Since the molten glass is flowable, aggregation of a glass body may occur in some cases. Also, when the glass is localized at the interface between the glass and the fluorescent body, reaction with the fluorescent body may occur in some cases. As a result, the joining strength between the fluorescent body and the reflection film may be deteriorated, or the reflectance of the reflection film may decrease.

The present invention has been conceived so as to at least partially solve the aforementioned problem. Thus, an object of the invention is to provide a wavelength conversion member in which the joining strength between a fluorescent body and a reflection film is enhanced, and a drop in reflectance of a reflection film can be suppressed. Another object is to provide a light source device.

### Means for Solving the Problems

The present invention has been conceived so as to at least partially solve the aforementioned problem, and may be embodied as the following aspects.

(1) According to one aspect of the present invention, a wavelength conversion member is provided. The wavelength conversion member includes a fluorescent body capable of emitting fluorescence by excitation light, and having an incident surface which the excitation light enters and a back surface disposed on the side opposite to the incident surface, and a reflection film disposed on the back surface side of the fluorescent body and formed of a metal layer and particles contained in the metal layer. A characteristic feature of the wavelength conversion member resides in that the particles have a melting point higher than that of the metal forming the metal layer; the reflection film has a first surface facing the back surface of the fluorescent body, and a second surface disposed on the side opposite to the first surface; and the particles are contained in an amount greater on the second surface side than on the first surface side.
   According to the above configuration, the melting point of the particles is higher than the melting point of the metal forming the metal layer, and such particles are contained in an amount greater on the second surface side than on the first surface side. In production of the wavelength conversion member having such a characteristic, particularly in the step of forming the reflection film on the back surface of the fluorescent body, when the material of the reflection film (i.e., a material including the metal forming the metal layer and the particles) is heated at a temperature equal to or higher than the melting point of the metal forming the metal layer and lower than the melting point of the particles, the metal forming the metal layer is in a molten state. Thus, the reflection film can be formed on the back surface of the fluorescent body, while high adhesion of the metal layer to the fluorescent body is maintained. As a result, the joining strength between the fluorescent body and the reflection film can be enhanced. Also, in formation of the reflection film on the back surface of the fluorescent body, the particles present on the second surface side are not melted, and the amount thereof is greater than that on the first surface side. In such a case, the surface tension of each particle to the molten metal resists the surface tension of the fluorescent body to the molten metal. Thus, the force to aggregate the metal particles with respect to the fluorescent body is weakened, to thereby suppress aggregation of the molten metal layer. In other words, extension of the reflection film over the fluorescent body can be facilitated. From such a viewpoint, the joining strength between the fluorescent body and the reflection film can be enhanced. Furthermore, in formation of the reflection film on the back surface of the fluorescent body, the particles present on the first surface side are not melted, similar to the particles present on the second surface side, and the amount thereof is smaller than that on the second surface side. In such a case, there can be suppressed a drop in reflectance of the reflection film, which would otherwise be caused by reaction of the molten particles with the back surface of the fluorescent body or a reduction of the area of the metal layer exposed to the first surface due to concentration of the particles on the first surface side. Therefore, according to the above characteristic feature, a wavelength conversion member in which a drop in reflectance of the reflection film is suppressed can be provided, while the joining strength between the fluorescent body and the reflection film is enhanced.
(2) In the wavelength conversion member of the above aspect, the particles may have a specific gravity smaller than that of the metal layer.
   According to the characteristic feature, in production of the wavelength conversion member, the particles can be easily localized upward in the gravity direction in the metal layer in a molten state. As a result, when the reflection film is formed on the back surface of the fluorescent body, the reflection film is formed on the back surface of the fluorescent body facing upward in the gravity direction by use of the metal layer and the particles in a heated state, whereby localization of the particles on the second surface side can be facilitated. Thus, a wavelength conversion member, in which the particles are present in an amount greater on the second surface side than on the first surface side, can be provided at high precision.
(3) In the wavelength conversion member of the above aspect, the particle size of the particles may be half or smaller than the thickness of the reflection film, when the distance between the first surface and the second surface is defined as the thickness of the reflection film.
   When the particle size of the particles increases, the thickness of the metal layer occupying the thickness of the reflection film relatively decreases, and through holes may be provided in the metal layer at higher possibility. In other words, when viewed from above, a portion containing no metal layer may be provided in the reflection film at higher possibility. Thus, according to the above configuration, possibility of providing through holes in the metal layer can be reduced, whereby a drop in reflection performance of the reflection film can be suppressed.
(4) In the wavelength conversion member of the above aspect, the material forming the particles may include a material included in the fluorescent body.
   According to the above technical feature, the difference in thermal expansion coefficient between the particles and the fluorescent body can be reduced. Thus, since the temperature range in which excessive thermal expansion of the particles is inhibited widely overlaps with the temperature range in which excessive thermal expansion of the fluorescent body is inhibited, the allowable temperature range in which excessive thermal expansion of the particles and the fluorescent body is inhibited can be widely provided, with respect to heating in production of the wavelength conversion member or thermal conversion of incident excitation light. That is, according to the technical feature, there can be prevented undesired phenomena such as cracking, deformation, delamination of the reflection film from the fluorescent body, etc., which would otherwise be caused by excessive thermal expansion of the fluorescent body or the particles. In addition, a compositional change due to reaction at the interface between the fluorescent body and the particles can also be suppressed.
(5) In the wavelength conversion member of the above aspect, the device may further have a heat radiation member which is disposed on the second surface side of the reflection film, and which can radiate the heat generated in the fluorescent body to the outside.
   According to the above configuration, the heat radiation member can radiate the heat generated through thermal conversion of a part of the excitation light which has entered the fluorescent body to the outside of the wavelength conversion member. As a result, thermal quenching, which evokes a decrease in fluorescence from the fluorescent body due to a rise in temperature, can be suppressed. Thus, a decrease in fluorescence emitted by the fluorescent body can be suppressed.
(6) In another aspect of the present invention, there is provided a light source device. A characteristic feature of the light source device resides in that the device includes the wavelength conversion member of the above aspect, and a light source which irradiates the incident surface with the excitation light.

According to the above configuration, the excitation light emitted from the light source to the fluorescent body is converted to the fluorescence emitted from the fluorescent body. Since the reflection film contains particles in an amount greater on the second surface side than on the first surface side, a drop in reflectance is suppressed. Therefore, a drop in light intensity of the excitation light which has passed through the fluorescent body included in the excitation light which has entered the fluorescent body and that of the fluorescence going toward the back surface side included in the fluorescence emitted by the fluorescent body are suppressed. In such a state, the excitation light and the fluorescence can be reflected toward the fluorescent body side. In addition, in the thus-provided light source device having such a reflection film, a drop in reflectance of the reflection film is suppressed, and the joining strength between the fluorescent body and the reflection film is enhanced.

Meanwhile, the present invention can be embodied in various modes. Specifically, the invention can be embodied as, for example, a wavelength conversion member, a light source device, a light-emitting device, a lighting fixture, a device including any of these, or a method for producing any of these.

### Brief Description of the Drawings

[Fig. 1] A schematic view showing a cross-section configuration of a wavelength conversion member.
[Fig. 2] A flowchart showing a method of producing a wavelength conversion member.
[Fig. 3] Views of production steps of a wavelength conversion member.

### Modes for Carrying Out the Invention

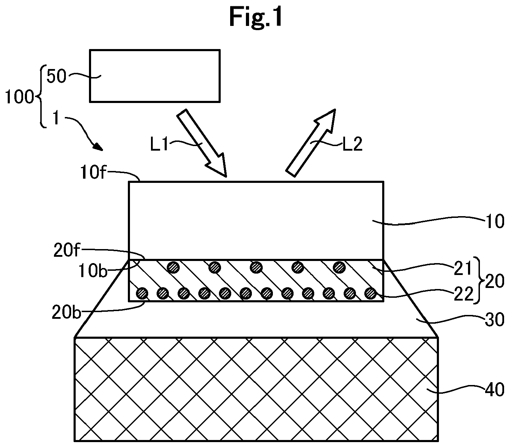

Fig. 1 is a schematic view showing a cross-sectional configuration of a wavelength conversion member 1 according to one embodiment of the present invention. The wavelength conversion member 1 is a member which converts excitation light L1 emitted from a light source 50 such as a light-emitting diode (LED: Light Emitting Diode) or a semiconductor laser (LD: Laser Diode) to fluorescence L2 having a wavelength different from that of the light L1. The wavelength conversion member 1 is employed in various optical instruments such as head lamps, lighting fixtures, and projectors. The wavelength conversion member 1 shown in Fig. 1 is a part of a light source device 100. The light source device 100 includes the wavelength conversion member 1, and the light source 50 which emits the excitation light L1. The wavelength conversion member 1 has a fluorescent body 10, a reflection film 20, a joining layer 30, and a heat radiation member 40.

The fluorescent body 10 emits fluorescence L2 by the emitted excitation light L1. The fluorescent body 10 has an incident surface 10f and a back surface 10b. The incident surface 10f is a surface on which the excitation light L1 is incident, and the back surface 10b is present on the side opposite the incident surface 10f. The fluorescent body 10 is formed of a ceramic sintered body, including a fluorescent phase mainly containing fluorescent crystal grains, and a translucent phase mainly containing translucent crystal grains. The crystal grains of the translucent phase are formed of Al₂O₃ (alumina). The crystal grains of the fluorescent phase are preferably have a composition represented by A₃B₅O₁₂:Ce (i.e., a garnet structure). The formula "A₃B₅O₁₂:Ce" refers to that Ce is dissolved in A₃B₅O₁₂ to form a solid solution in which element A is partially substituted by Ce.

Elements A and B present in A₃B₅O₁₂:Ce consist of at least one element selected from each of the following groups.
Element A: lanthanoids excepting Sc, Y, and Ce (however, Gd may be further included as element A.)
Element B: Al (however, Gd may be further included as element B.)

When the fluorescent body 10 is formed from the ceramic sintered body, light scattering occurs at the interface between the fluorescent phase and the translucent phase, to thereby reduce angle dependency of the color of light. As a result, color uniformity can be enhanced. Notably, the material of the fluorescent body 10 is not limited to the aforementioned materials.

The reflection film 20 is disposed on the back surface 10b side of the fluorescent body 10, and reflects, toward the fluorescent body 10, excitation light which has passed through the fluorescent body 10 included in the excitation light L1 incident on the fluorescent body 10, and fluorescence going to the back surface 10b included in the fluorescence L2 emitted from the fluorescent body 10. The reflection film 20 has a first surface 20f and a second surface 20b. The first surface 20f is a surface oppositely facing to the back surface 10b of the fluorescent body 10. The second surface 20b is a surface disposed on the side opposite to the first surface 20f.

The reflection film 20 is formed of a metal layer 21 and particles 22. Examples of the metal forming the metal layer 21 include silver (Ag), platinum (Pt), aluminum (Al), and a silver alloy. In the present embodiment, the metal forming the metal layer 21 is silver (Ag). The particles 22 are accommodated in the metal layer 21. Examples of the particles 22 include particles of a ceramic such as Al₂O₃, YAG, TiO₂, Y₂O₃, SiO₂, Cr₂O₃, Nb₂O₅, or Ta₂O₅; and particles of a metal such as Ni, W, Mo, Cr, or Nb. In the present embodiment, the particles 22 are formed of Al₂O₃. That is, since the material of the particles 22 is Al₂O₃, which is the same material of the crystal grains forming the translucent phase of the fluorescent body 10, the material forming the particles 22 includes the material contained in the fluorescent body 10. The ratio by volume of the particles 22 occupying the reflection film 20 is preferably 0.1 to 20.0% with respect to the volume of the metal layer 21 occupying the reflection film. When the distance between the first surface 20f and the second surface 20b is defined as the thickness of the reflection film 20, the thickness is preferably 1 to 100 micrometers, and the particle size of the particles 22 is preferably 0.5 to 50 micrometers. In the present embodiment, the particle size of the particles 22 is equal to or less than the half value of the thickness of the reflection film 20. Notably, the particle size of the particles 22 employed in the embodiment is obtained by selecting at random 100 particles 22 in a cross-section image observed under a scanning electron microscope (SEM) and averaging.

The melting point of the particles 22 in the reflection film 20 is higher than the melting point of the metal forming the metal layer 21. Notably, the melting point of Al₂O₃ forming the particles 22 of the present embodiment is 2,072 degrees Celsius, and the melting point of Ag (silver) forming the metal layer 21 is 961.8 degrees Celsius. Also, the specific gravity of the particles 22 is smaller than that of the metal layer 21.

As shown in Fig. 1, the particles 22 are contained in an amount greater on the second surface 20b side than on the first surface 20f side. Such a distribution of the particles 22 is confirmed through an analysis of a cross-section image observed under a scanning electron microscope (SEM). Specifically, the distribution of the particles 22 is confirmed through comparison of the distribution of the particles 22 in the vicinity of the first surface 20f with that in the vicinity of the second surface 20b, in a cross-section orthogonal to the incident surface 10f of the fluorescent body 10 (see, for example, a cross-section shown in Fig. 1). The distribution of the particles 22 in the vicinity of the first surface 20f is represented by a value obtained by dividing the cross-section of the particles 22 present in an area defined by a 10% depth portion of the thickness of the reflection film 20 from the first surface 20f (i.e., the length between the first surface 20f and the second surface 20b) by a cross-sectional area of the metal layer 21 present in the same area. Similarly, the distribution of the particles 22 in the vicinity of the second surface 20b is represented by a value obtained by dividing the cross-section area of the particles 22 present in an area defined by a 10% depth portion of the thickness of the reflection film 20 from the second surface 20b by a cross-sectional area of the metal layer 21 present in the same area. Notably, Fig. 1 schematically shows the distribution of the particles 22 in the reflection film 20. Thus, the particles 22 present on the first surface 20f side and the particles 22 present on the second surface 20b side are not necessarily distributed in a uniform (equi-distance) manner. Also, the particles 22 may be present in a center portion of the reflection film 20 between the first surface 20f and the second surface 20b. Needless to say, the ratio of the particles 22 present on the first surface 20f side to the particles 22 present on the second surface 20b side may also be a value differing from that shown in Fig. 1.

The joining layer 30 is disposed between the reflection film 20 and the below-mentioned heat radiation member 40 and joins the reflection film 20 to the heat radiation member 40. The joining layer 30 is formed of an Au-Sn solder containing gold (Au) and tin (Sn). Notably, the material of the joining layer 30 is not limited to the Au-Sn solder, and may be a solder such as an Sn-Pb solder, an Sn-Ag-Cu solder, an Sn-Zn-Bi solder, an Sn-Cu solder, or an Sn-Ag-In-Bi solder. Alternatively, the joining layer 30 may be formed by, for example, sintering micropowders of, for example, silver (Ag) or copper (Cu).

The heat radiation member 40 is disposed on the second surface 20b side of the reflection film 20 and radiates heat generated in the fluorescent body 10 to the outside of the wavelength conversion member 1. In the present embodiment, the heat radiation member 40 is disposed on a surface opposite to the surface joined to the reflection film 20, included in the joining layer 30. Examples of the material forming the heat radiation member 40 include copper, a copper-molybdenum alloy, a copper-tungsten alloy, and aluminum, which have a thermal conductivity higher than that of the fluorescent body 10. In the present embodiment, the material forming the heat radiation member 40 is copper.

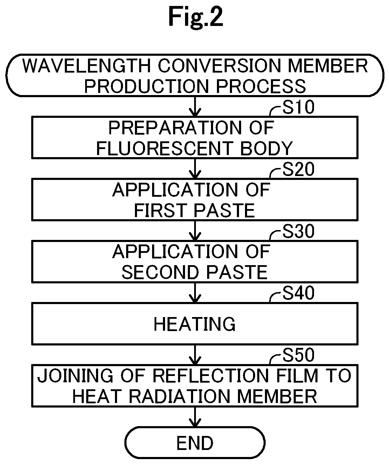

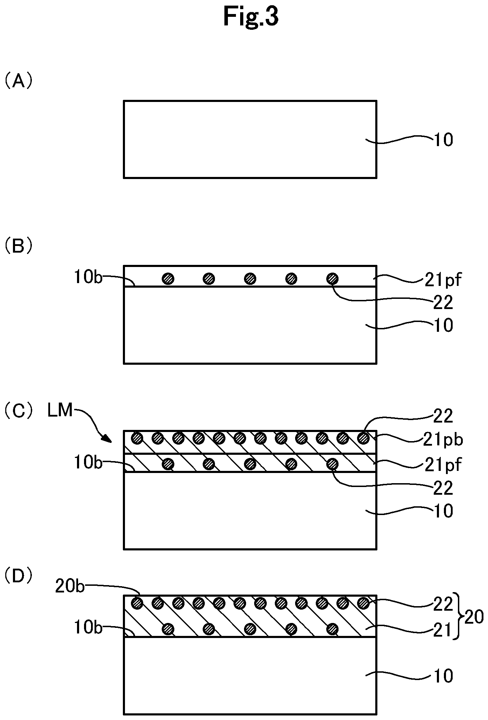

Fig. 2 is a flowchart showing a method of producing the wavelength conversion member 1. (A) to (D) of Fig. 3 show steps of producing the wavelength conversion member 1. In production of the wavelength conversion member 1, as shown in (A) of Fig. 3, firstly, the fluorescent body 10 is provided (Step S10). More specifically, materials of forming a fluorescent phase and a translucent phase is pulverized with ethanol under mixing, to thereby prepare a slurry. The slurry is dried and granulated. To the obtained powder, a binder and water are added, and the mixture is kneaded, to thereby provide a material paste. The material paste is molded and fired, to thereby prepare the fluorescent body 10. Next, as shown in (B) of Fig. 3, a first paste 21pf is applied onto the back surface 10b of the fluorescent body 10 (Step S20). More specifically, the first paste 21pf is applied onto the back surface 10b of the fluorescent body 10, while the back surface 10b faces upward in the gravity direction. The first paste 21pf has been prepared in advance by mixing a metal powder and the particles 22 forming the metal layer 21 with an acrylic binder and a solvent.

Subsequently, as shown in (C) of Fig. 3, a second paste 21pb is applied onto a surface of the first paste 21pf opposite to the back surface 10b (Step S30). The second paste 21pb is the same as the first paste 21pf, except that the second paste 21pb contains the particles 22 in a larger amount as compared with the first paste 21pf. A laminate LM is a laminate in which the fluorescent body 10, the first paste 21pf, and the second paste 21pb are sequentially stacked. Next, the laminate LM is heated at a temperature equal to or higher than the melting point of the metal contained in the first and second pastes 21pf, 21pb, and lower than the melting point of the particles 22, to thereby integrate the first paste 21pf with the second paste 21pb by fusion. As a result, as shown in (D) of Fig. 3, the reflection film 20 is formed on the back surface 10b of the fluorescent body 10 (Step S40). Notably, in fusion of the first paste 21pf with the second paste 21pb, since the specific gravity of the particles 22 contained in each of the pastes is smaller than that of the metal contained in each of the pastes, a part of the particles 22 contained in the first paste 21pf moves toward the second paste 21pb side (not illustrated in (D) of Fig. 3). The amount of the particles 22 moving is controlled by temperature and time of heating. Then, the reflection film 20 is joined to the heat radiation member 40 by the mediation of the joining layer 30 (Step S50). Thus, the method of producing the wavelength conversion member 1 is complete.

As described above, according to the wavelength conversion member 1 of the present embodiment, the melting point of the particles 22 is higher than that of the metal forming the metal layer 21. These particles 22 are present in an amount greater on the second surface 20b side than on the first surface 20f side. In production of the wavelength conversion member 1 having such a characteristic, particularly in the step of forming the reflection film 20 on the back surface 10b of the fluorescent body 10, when the material of the reflection film 20 (i.e., a material including the metal forming the metal layer 21 and the particles 22) is heated at a temperature equal to or higher than the melting point of the metal forming the metal layer 21 and lower than the melting point of the particles 22 (corresponding to Step S40 of Fig. 2), the metal forming the metal layer 21 is in a molten state. Thus, the reflection film 20 can be formed on the back surface 10b of the fluorescent body 10, while high adhesion of the metal layer 21 to the fluorescent body 10 is maintained. As a result, the joining strength between the fluorescent body 10 and the reflection film 20 can be enhanced. Also, in formation of the reflection film 20 on the back surface 10b of the fluorescent body 10, the particles 22 present on the second surface 20b side are not melted, and the amount thereof is greater than that on the first surface 20f side. In such a case, the surface tension of each particles 22 to the molten metal rebels against the surface tension of the fluorescent body 10 to the molten metal. Thus, the force to aggregate the metal particles with respect to the fluorescent body 10 is weakened, to thereby suppress aggregation of the molten metal layer 21. In other words, extension of the reflection film 20 over the fluorescent body 10 can be facilitated. From the viewpoint, the joining strength between the fluorescent body 10 and the reflection film 20 can be enhanced. Furthermore, in formation of the reflection film 20 on the back surface 10b of the fluorescent body 10, the particles 22 present on the first surface 20f side are not melted, similar to the particles 22 present on the second surface 20b side, and the amount thereof is smaller than that on the second surface 20b side. In such a case, there can be suppressed a drop in reflectance of the reflection film 20, which would otherwise be caused by reaction of the molten particles 22 with the back surface 10b of the fluorescent body 10 or a reduction of the area of the metal layer 21 exposed to the first surface 20f due to concentration of the particles 22 on the first surface 20f side. Therefore, according to the wavelength conversion member 1 of the present embodiment, there can be provided the wavelength conversion member 1 in which a drop in reflectance of the reflection film 20 is suppressed, while the joining strength between the fluorescent body 10 and the reflection film 20 is enhanced.

Also, in the wavelength conversion member 1 of the present embodiment, the particles 22 are formed of Al₂O₃. Since Al₂O₃ has high translucent property, absorption of excitation light and fluorescence reaching a portion on the reflection film 20 by the particles 22 can be suppressed. Thus, a drop of reflectance of the reflection film 20 can be suppressed.

In the wavelength conversion member 1 of the present embodiment, the specific gravity of the particles 22 is smaller than that of the metal layer 21. Thus, in production of the wavelength conversion member 1, the particles 22 can be easily localized upward in the gravity direction in the metal layer 21 in a molten state. As a result, when the reflection film 20 is formed on the back surface 10b of the fluorescent body 10, the reflection film 20 is formed on the back surface 10b of the fluorescent body 10 facing upward in the gravity direction by use of the metal layer 21 and the particles 22 in a heated state (see Fig. 3), whereby localization of the particles 22 on the second surface 20b side can be facilitated. Thus, the wavelength conversion member 1, in which the particles 22 are present in an amount greater on the second surface 20b side than on the first surface 20f side, can be provided at high precision.

Also, in the wavelength conversion member 1 of the present embodiment, the particle size of the particles 22 is half or less than the thickness of the reflection film 20. When the particle size of the particles 22 increases, the thickness of the metal layer 21 occupying the thickness of the reflection film 20 relatively decreases, and through holes may be provided in the metal layer 21 at higher possibility. In other words, when viewed from above, a portion containing no metal layer 21 may be provided in the reflection film 20 at higher possibility. Thus, in the wavelength conversion member 1, possibility of providing through holes in the metal layer 21 can be reduced, whereby a drop in reflection performance of the reflection film can be suppressed.

Yet in the wavelength conversion member 1 of the present embodiment, the material of the particles 22 includes the material contained in the fluorescent body 10. Therefore, the difference in thermal expansion coefficient between the particles 22 and the fluorescent body 10 can be reduced. Accordingly, since the temperature range in which excessive thermal expansion of the particles 22 is inhibited widely overlaps with the temperature range in which excessive thermal expansion of the fluorescent body 10 is inhibited, the allowable temperature range in which excessive thermal expansion of the particles 22 and the fluorescent body 10 is inhibited can be widely provided, with respect to heating in production of the wavelength conversion member 1 or thermal conversion of incident excitation light L1. That is, in the wavelength conversion member 1, there can be prevented undesired phenomena such as cracking, deformation, delamination of the reflection film from the fluorescent body, etc., which would otherwise be caused by excessive thermal expansion of the fluorescent body 10 or the particles 22. In addition, a compositional change due to reaction at the interface between the fluorescent body 10 and the particles 22 can also be suppressed.

The wavelength conversion member 1 of the present embodiment has the heat radiation member 40 that can radiate heat generated in the fluorescent body 10 to the outside. Thus, the heat radiation member 40 can radiate the heat generated through thermal conversion of a part of the excitation light L1 which has entered the fluorescent body 10 to the outside of the wavelength conversion member 1. As a result, thermal quenching, which evokes a decrease in fluorescence from the fluorescent body 10 due to a rise in temperature, can be suppressed. Thus, a decrease in fluorescence emitted by the fluorescent body 10 can be suppressed.

According to the light source device 100 of the present embodiment, the excitation light L1 emitted from the light source 50 to the fluorescent body 10 is converted to the fluorescence L2 emitted from the fluorescent body 10. Since the reflection film 20 contains particles in an amount greater on the second surface 20b side than on the first surface 20f side, a drop in reflectance is suppressed. Therefore, a drop in light intensity of the excitation light which has passed through the fluorescent body 10 included in the excitation light L1 which has entered the fluorescent body 10 and that of the fluorescence going toward the back surface side included in the fluorescence L2 emitted by the fluorescent body 10 are suppressed. In such a state, the excitation light and the fluorescence can be reflected toward the fluorescent body 10 side. In addition, in the light source device 100 having such a reflection film 20, a drop in reflectance of the reflection film 20 is suppressed, and the joining strength between the fluorescent body 10 and the reflection film 20 is enhanced.

### <Variations of the present embodiment>

The present invention is not limited to the aforementioned embodiment and may be carried out in various modes, so long as they do not deviate the gist of the invention. For example, the following variations may be encompassed in the invention.

In the aforementioned embodiment as shown in Fig. 1, the reflection film 20 is disposed so as to be in direct contact with the back surface 10b of the fluorescent body 10. However, the configuration is not limited thereto. For example, so long as the reflection film 20 is disposed on the back surface 10b side of the fluorescent body 10, an additional member may be inserted between the reflection film 20 and the fluorescent body 10. Examples of the additional member include an adhesion film and a reflection-enhancing film. Even such an additional member is inserted between the reflection film 20 and the fluorescent body 10, the reflection film 20 can be formed with high adhesion to the additional member and the fluorescent body 10.

As described in relation to the aforementioned embodiment, the material of the particles 22 is not limited to Al₂O₃. For example, the particles 22 may be formed of YAG. In the case where the reflection film 20 contains the particles 22 formed of YAG, YAG can absorb blue light included in the excitation light or the fluorescence which reached the reflection film 20 side. In this case, yellow light can be emitted.

In the aforementioned embodiment, the material of the particles 22 is Al₂O₃, which is the same as that of the crystal grains of the translucent phase of the fluorescent body 10. However, the material is not limited thereto. So long as the material of the particles 22 includes at least a part of the materials contained in the fluorescent body 10, the material may further include a material different from that of the fluorescent body 10. In the case where the material contained in the fluorescent body 10 is not included in the material forming the particles 22, the material forming the particles 22 preferably contains a material having a thermal expansion coefficient equivalent to that of the material contained in the fluorescent body 10.

In the aforementioned embodiment, the particles 22 are formed of Al₂O₃, and the metal layer 21 is formed of silver (Ag). However, the configuration is not limited thereto. For example, each of the particles 22 and the metal layer 21 may be formed of a plurality of materials. In such a case, the expression "the melting point of the particles 22 is higher than that of the metal forming the metal layer 21" means that the melting point of the material having the lowest melting point among the materials forming the particles 22 is higher than that of the material having the highest melting point among the plurality of materials forming the metal layer 21.

In the aforementioned embodiment, the reflection film 20 is formed from two pastes having two different particle contents (first and second pastes 21pf, 21pb). However, the feature is not limited thereto. For example, so long as the paste forming the reflection film 20 contains the metal forming the metal layer 21 and the particles 22 having a specific gravity smaller than that of the material, the reflection film may be formed from a paste of a single component or three or more components.

As described hereinabove, the modes of the invention has been described on the basis of the embodiment and variations. However, the aforementioned embodiment of the aforementioned modes are given for the purpose of easily understanding the modes, and should not be construed as limiting the invention thereto. The modes may be modified or improved, so long as they do not deviate the gist and claims of the invention, and encompass an equivalent thereof. Also, if the technical features thereof are not mentioned as essential elements, they may be appropriately deleted.

The present invention may also be embodied as the following examples.

### [Application Example 1]

A wavelength conversion member, including
a fluorescent body capable of emitting fluorescence by excitation light, and having an incident surface which the excitation light enters and a back surface disposed on the side opposite to the incident surface, and
a reflection film disposed on the back surface side of the fluorescent body and formed of a metal layer and particles contained in the metal layer,
characterized in that
the particles have a melting point higher than that of the metal forming the metal layer;
the reflection film has
a first surface facing the back surface of the fluorescent body, and
a second surface disposed on the side opposite to the first surface; and
the particles are contained in an amount greater on the second surface side than on the first surface side.

### [Application Example 2]

A wavelength conversion member as described in Application Example 1, characterized in that
the particles have a specific gravity smaller than that of the metal layer.

### [Application Example 3]

A wavelength conversion member as described in Application Example 1 or 2, characterized in that
the particle size of the particles is half or smaller than the thickness of the reflection film, when the distance between the first surface and the second surface is defined as the thickness of the reflection film.

### [Application Example 4]

A wavelength conversion member as described in any of Application Examples 1 to 3, characterized in that
the material forming the particles includes a material included in the fluorescent body.

### [Application Example 5]

A wavelength conversion member as described in any of Application Examples 1 to 4, characterized in that
the member further has a heat radiation member which is disposed on the second surface side of the reflection film, and which can radiate the heat generated in the fluorescent body to the outside.

### [Application Example 6]

A light source device characterized by having
a wavelength conversion member as recited in any of Application Examples 1 to 5, and
a light source which irradiates the incident surface with the excitation light. Reference Numerals of the Drawings

- 1: wavelength conversion member
- 10: fluorescent body
- 10f: incident surface
- 10b: back surface
- 20: reflection film
- 20f: first surface
- 20b: second surface
- 21: metal layer
- 21pf: first paste
- 21pb: second paste
- 22: particle
- 30: joining layer
- 40: heat radiation member
- 50: light source
- 100: light source device

## Claims

1. A wavelength conversion member, comprising:
a fluorescent body capable of emitting fluorescence by excitation light, and having an incident surface which the excitation light enters and a back surface disposed on the side opposite to the incident surface, and
a reflection film disposed on the back surface side of the fluorescent body and formed of a metal layer and particles contained in the metal layer,
**characterized in that**
the particles have a melting point higher than that of the metal forming the metal layer;
the reflection film has
a first surface facing the back surface of the fluorescent body, and
a second surface disposed on the side opposite to the first surface side; and
the particles are contained in an amount greater on the second surface side than on the first surface side.

2. A wavelength conversion member according to claim 1,
wherein the particles have a specific gravity smaller than that of the metal layer.

3. A wavelength conversion member according to claim 2,
wherein the particle size of the particles is half or smaller than the thickness of the reflection film, when the distance between the first surface and the second surface is defined as the thickness of the reflection film.

4. A wavelength conversion member according to claim 3,
wherein the material forming the particles includes a material included in the fluorescent body.

5. A wavelength conversion member according to claim 4,
wherein the member further includes a heat radiation member which is disposed on the second surface side of the reflection film, and which can radiate the heat generated in the fluorescent body to the outside.

6. A light source device comprising:
a wavelength conversion member as recited in any one of claims 1 to 5, and
a light source which irradiates the incident surface with the excitation light.
